Europäisches Patentamt

European Patent Office

Office européen des brevets

(19)

(11) Veröffentlichungsnummer : **0 067 145**
**B1**

# EUROPÄISCHE PATENTSCHRIFT

(12)

(45) Veröffentlichungstag der Patentschrift :
25.07.84

(21) Anmeldenummer : 82890081.1

(22) Anmeldetag : 26.05.82

(51) Int. Cl.³ : **E 21 C 35/22**

(54) **Einrichtung zum Kühlen der Meissel einer Schrämmaschine.**

(30) Priorität : 04.06.81 AT 2519/81

(43) Veröffentlichungstag der Anmeldung :
15.12.82 Patentblatt 82/50

(45) Bekanntmachung des Hinweises auf die Patenterteilung : 25.07.84 Patentblatt 84/30

(84) Benannte Vertragsstaaten :
DE FR GB

(56) Entgegenhaltungen :
EP-A- 0 060 827
DE-A- 2 363 372

(73) Patentinhaber : **VOEST-ALPINE Aktiengesellschaft**
**Friedrichstrasse 4**
**A-1011 Wien (AT)**

(72) Erfinder : **Zitz, Alfred**
**Granitzenweg 13b**
**A-8740 Zeltweg (AT)**
Erfinder : **Schetina, Otto, Dipl.Ing.**
**Bessemerstrasse 36**
**A-8740 Zeltweg (AT)**
Erfinder : **Wrulich, Herwig**
**Haldenweg 4**
**A-8740 Zeltweg (AT)**

(74) Vertreter : **Kretschmer, Adolf, Dipl.-Ing. et al**
**Patentanwälte Dipl.Ing. A. Kretschmer Dr. Thomas M.**
**Haffner Schottengasse 3a**
**A-1014 Wien (AT)**

EP 0 067 145 B1

**Beschreibung**

Die Erfindung bezieht sich auf eine Einrichtung zum Kühlen der Meißel einer Schrämmaschine mit einer im Bereich des Meißels angeordneten Düse für das unter Druck auszuspritzende Kühlwasser, zu welcher die Wasserzufuhr durch ein Absperrventil absperrbar ist, wobei der Meißel am Meißelhalter entgegen einer durch die Kraft einer Feder und den Wasserdruck gebildeten Rückstellkraft durch den Schnittdruck begrenzt axial verschiebbar gelagert ist und das Absperrventil mit dem Meißel durch ein Kuppelglied derart gekuppelt ist, daß es bei einer Verschiebebewegung des Meißels in Richtung des Schnittdruckes öffnet. Eine solche Einrichtung ist aus der eigenen älteren EP-A-60 827 bekannt, die unter Art. 54 (3) und (4) des EPÜ fällt. Die Meißel sind beispielsweise an einem Schrämkopf oder einer Schrämwalze angeordnet. Die oben beschriebene Einrichtung ist jedem Meißel oder nur denjenigen Meibeln zugeordnet, welche höher beansprucht sind.

Die Erfindung stellt sich zur Aufgabe, bei einer solchen Einrichtung eine noch weitergehende Wasseresparnis zu erzielen und besteht im wesentlichen darin, daß die den Meißel entgegen dem Schnittdruck belastende Rückstellkraft so bemessen ist, daß sie erst bei einer einachsigen Würfeldruckfestigkeit des zu schrämenden Gesteins von mindestens 20 N/mm² überwunden wird.

Die Kühlung des Meißels durch einen Wasserstrahl ist in erster Linie wichtig, um eine Funkenbildung zu vermeiden. Eine solche Funkenbildung bringt insbesondere beim Schrämen von Kohle eine Explosionsgefahr mit sich. Die Erfindung geht nun von der Erkenntnis aus, daß die Gefahr einer Funkenbildung nur bei härterem Gestein besteht, während eine Funkenbildung beim Schrämen von weicherem Gestein nicht in Betracht kommt.

Bei einem Gestein von großer Härte bzw. großer Festigkeit ist der den Meißel belastende Schnittdruck größer als bei weichem Gestein. Erst wenn die auf den Meißel entgegen dem Schnittdruck wirkende Rückstellkraft durch den Schnittdruck überwunden wird, öffnet das Ventil und das Kühlwasser wird gegen den Meißel und die Ortsbrust gespritzt. Diese Rückstellkraft ist nun erfindungsgemäß so groß bemessen, daß sie erst dann durch den Schnittdruck überwunden wird, wenn der Meißel auf ein Gestein von einer vorbestimmten Festigkeit, nämlich von einer einachsigen Würfeldruckfestigkeit von mindestens 20 N/mm² auftritt, überwunden wird. Dadurch wird der Zeitraum des Ausspritzens des Kühlwassers aus der Düse auf die Zeiträume beschränkt, in welchen der Meißel auf das Gestein großer Festigkeit auftrifft, und es wird die Kühlung und damit der Wasserverbrauch auf das zur Vermeidung einer Funkenbildung notwendige Ausmaß eingeschränkt.

Gemäß der Erfindung beträgt die Rückstellkraft vorzugsweise mindestens 3 000 N.

Gemäß einer bevorzugten Ausführungsform der Erfindung kann die Feder gegen ein verstellbares und im Betrieb festlegbares Widerlager abgestützt sein. Auf diese Weise kann die Rückstellkraft an verschiedene Würfeldruckfestigkeiten angepaßt werden, wobei dem jeweils zu schrämenden Gestein Rechnung getragen werden kann. Bei einer Anordnung, bei welcher die Feder in an sich bekannter Weise von einer auf den Ventilkegel wirkenden und gleichachsig mit diesem angeordneten Schraubenfeder gebildet ist, kann hiebei das Widerlager von einem im Ventilgehäuse oder im Meißelhalter verschraubbaren Federteller gebildet sein.

Vorzugsweise ist die Anordnung so getroffen, daß das Absperrventil in an sich bekannter Weise mit einem entgegen der Strömungsrichtung des Wassers öffnenden Ventilkegel ausgebildet ist, der einen im Ventilgehäuse dicht geführten Ventilschaft aufweist, und daß mit dem Ventilkegel ein in Strömungsrichtung hinter demselben angeordneter, in einem Zylinder dicht geführter Kolben starr verbunden ist, wobei in einem Raum zwischen dem Ventilkegel und dem Kolben wenigstens eine Austrittsöffnung für das Wasser mündet. Der Druck des Wassers vor der Düse ist, um einen scharfen Strahl zu erreichen, zweckmäßig verhältnismäßig hoch gewählt und kann etwa 200 bar oder auch mehr betragen. Dieser Druck würde nun, da das Kegelventil entgegen der Strömungsrichtung öffnet, bei offenem Ventil auf den Ventilkegel im Öffnungssinn wirken. Um diesen Druck zu überwinden und das Schließen des Ventiles zu bewirken, wäre eine sehr hohe Federkraft und damit eine starke Feder, durch welche die Baumaße vergrößert werden würden, erforderlich. Dadurch, daß mit dem Ventilkegel ein in einem Zylinder dicht geführter Kolben starr verbunden ist, wirkt der im Raum hinter dem Ventilkegel auftretende Druck auf den Ventilkegel nur im Bereich einer Ringfläche, deren Größe der Differenz zwischen dem Querschnitt des Ventilschaftes und dem Querschnitt des Kolbens entspricht. Es wird dadurch ermöglicht, die den Ventilkegel belastende Feder schwächer und damit weniger umfangreich zu bemessen. Wenn der Durchmesser des Kolbens gleich dem Durchmesser des Ventilschaftes bemessen ist, gleicht sich der auf den Ventilkegel wirkende Druck des Wassers bei geöffnetem Ventil aus, so daß bei geöffneten Ventil nur durch die Kraft der Feder bestimmt ist. Gemäß einer bevorzugten Ausführungsform der Erfindung ist jedoch der Durchmesser des Kolbens größer als der Durchmesser des Schaftes des Ventilkegels. Bei geöffnetem Ventil wirkt daher der Wasserdruck auf eine Ringfläche, deren Größe dem Querschnitt des Kolbens abzüglich des Querschnittes des Ventilschaftes entspricht. Die bei geöffnetem Ventil auf den Ventilkegel im Sinne des Schließens wirkende Rückstellkraft ist daher die aus der Federkraft und dem auf diese Ringfläche wirkenden Wasserdruck resultierende Summenkraft. Bei geschlossenem Ventil wirkt der vor dem Ventil auftretende Wasserdruck auf eine Ringfläche, deren Größe dem Querschnitt des Randes der Sitzfläche des Kegelventiles abzüglich des Querschnittes des Ventilschaftes entspricht. Diese Ringfläche ist größer als die Ringfläche, welche dem Querschnitt des Kolbens abzüglich des Querschnittes des Ventilschaftes entspricht und es ist daher die Rückstellkraft, welche der Meißel beim Öffnen des Ventiles überwinden muß, größer als die Rückstellkraft, welche beim Schließen des Ventiles erforderlich ist. Es wird daher das Ventil bei einem größeren Schnittdruck öffnen und bei einem etwas kleineren Schnittdruck schließen. Dadurch wird ein Flattern des Ventils vermieden.

In der Zeichnung ist die Erfindung anhand eines Ausführungsbeispieles schematisch erläutert.

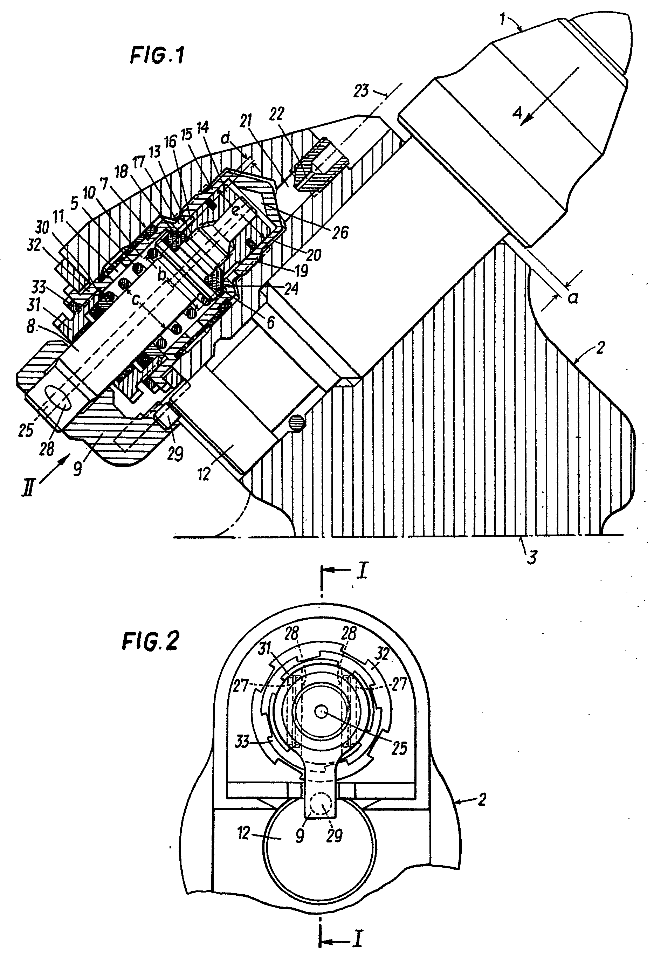

Figur 1 zeigt einen Schnitt durch den Meißelhalter und durch das Ventil in der Achse des Meißels und des Ventils nach Linie I-I der Fig. 2.

Figur 2 zeigt eine Ansicht in Richtung des Pfeiles II der Fig. 1.

Der Meißel 1 ist im Meißelhalter 2 axial um einer Weg a verschiebbar gelagert. 3 ist die Fläche des Meißelhalters, an welcher dieser mit dem Schrämkopf verschweißt ist. Der Meißel 1 ist entgegen dem in Richtung des Pfeiles 4 wirkenden Schnittdruck durch eine Feder 5 belastet. Diese Feder 5 greift am Ventilkegel 6 eines Ventiles 7 an und mit dem Schaft 8 des Ventilkegels 6 ist ein Finger 9 verbunden, der auf den Schaft 12 des Meißels 1 drückt und diesen entgegen dem in Richtung des Pfeiles 4 wirkenden Schnittdruck belastet. Das Druckwasser wird dem Raum 10 vor dem Ventilkegel 6 durch Öffnungen 11 über nicht dargestellte Kanäle im Schrämkopf und im Meißelhalter zugeführt und wirkt daher auf den Ventilkegel 6 im Schließsinne, d. h. in gleicher Richtung wie die Feder 5. Die über den Finger 9 auf den Meißel 1 entgegen dem in Richtung des Pfeiles 4 wirkenden Schnittdruck wirkende Kraft setzt sich daher aus der Kraft der Feder 5 und der durch den Wasserdruck wirkenden Kraft zusammen und die Summe dieser Kräfte muß so groß sein, daß der Meißel erst bei einer einachsigen Würfelfestigkeit des zu schrämende Gesteins von mindestens 20 N/mm² diese Kraft überwindet und damit den Ventilkegel 6 von seinem Sitz abhebt.

Mit dem Ventilkegel 6 ist ein Kolben 14 durch ein Schraubengewinde 13 verbunden, der in einem Zylinder 15 dicht geführt ist. Zwischen dem Ventilkegel 6 und dem Kolben 14 ist durch eine Eindrehung ein Raum 16 geschaffen, in welchen Austrittsöffnungen 17 für das Wasser münden. Bei von Sitz 18 abgehobenem Ventilkegel 6 strömt das Druckwasser aus dem Raum 10 in den Raum 16, von hier über die Austrittsöffnungen 17 über nicht dargestellte Nuten im Schraubengewinde 19, mit welchem der Zylinder 15 im Meißelhalter festgelegt ist und über einen Spalt 20 zwischen dem Zylinder 15 und der Bohrung des Meißelhalters zum Raum 21 vor der Düse 22, aus welcher es in einem scharfen Strahl 23 gegendie Orstsbrust im Bereich des Meißels 1 gespritzt wird. Der Wasserdruck im Raum 21 ist verhältnismäßig hoch und beträgt beispielsweise 200 bar, so daß sich ein scharfer Strahl 23 ausbildet.

Bei geschlossenem Ventil, d.h. wenn der Ventilkegel 6 auf dem Ventilsitz 18 aufsitzt, wirkt der Wasserdruck im Raum 10 auf eine Ringfläche, deren Größe dem Querschnitt b des äußeren Randes des Ventilsitzes 18 abzüglich des Querschnittes c des Ventilschaftes 8 entspricht. Sobald diese durch den Kraft der Feder 5 durch den in Richtung des Pfeiles 4 wirkenden Schnittdruck überwunden wird, öffnet das Ventil.

Sobald der Ventilkegel 6 vom Ventilisitz 18 abgehoben wird, baut sich im Raum 16 ein Wasserdruck auf, welcher um die Strömungsverluste vermindert dem Druck im Raum 10 entspricht. Dieser Wasserdruck wirkt bei geöffnetem Ventil auf eine Ringfläche d, deren Größe dem Querschnitt e des Kolbens 14 abzüglich des Querschnittes c des Ventilschaftes 8 entspricht. Da der Querschnitt c des Ventilschaftes 8 kleiner ist als der Querschnitt e des Kolbens 14, wirkt diese Kraft im Schließsinne des Ventiles. Die bei abgehobenem Ventilkegel 6 im Schließsinne des Ventils und entgegen dem in Richtung des Pfeiles 4 wirkenden Schnittdruck wirkende Rückstellkraft sezt sich daher aus der Kraft der Feder 5 und dem auf die Ringfläche d wirkenden Wasserdruck zusammen. Da die Ringfläche d kleiner ist als der Querschnitt b des äußeren Randes 24 des Ventilsitzes 18 abzüglich des Querschnittes c des Ventilschaftes 8, ist die durch den Wasserdruck ausgeübte Rückstellkraft bei geöffnetem Ventil geringer als bei geschlossenem Ventil. Es ist somit der Schnittdruck des Meißels, bei welchem das Ventil 7 öffnet, größer als der Schnittdruck des Meißels, bei welchem das Ventil 7 schließt, und es wird dadurch ein Flattern des Ventiles 7 und damit auch ein Flattern des Meißels 1 vermieden.

Das Widerlager der Feder 5 ist von einem Federteller 30, 31 gebildet, der im Ventilgehäuse 32 verschraubbar ist. Wenn dieser Federteller weiter in das Ventilgehäuse eingeschraubt wird, die Feder 5 stärker vorgespannt und die Rückstellkraft wird gröber. In der Entsprechenden Stellung kann der Ventilteller 30, 31 durch eine Kontramutter 33 fixiert werden. Auf diese Weise ist die Rückstellkraft einstellbar.

25 ist eine ins Freie mündende Bohrung im Ventilschaft, durch welche der Raum 26 oberhalb des Kolbens 14 drucklos gemacht wird. 27 sind in Nuten 28 des Ventilschaftes 8 eingreifende Keile, durch welche der Ventilschaft 8 mit dem Finger 9 verbunden ist. 29 ist ein Druckstück, über welches der Finger 9 auf den Meißelschaft 12 wirkt.

### Anprüche

1. Einrichtung zum Kühlen der Meißel (1) einer Schrämmaschine mit einer im Bereich des Meißels (1) angeordneten Düse (22) für das unter Druck auszuspritzende Kühlwasser, zu welcher die Wasserzufuhr durch ein Absperrventil (7) absperrbar ist, wobei der Meißel (1) am Meißelhalter (2) entgegen einer durch die Kraft einer Feder (5) und den Wasserdruck gebildeten Rückstellkraft durch den Schnittdruck begrenzt axial verschiebbar gelagert ist und das Absperrventil (7) mit dem Meißel durch ein Kuppelglied (9) derart gekuppelt ist, daß es bei einer Verschiebebewegung des Meißels in Richtung (4) des Schnittdruckes öffnet, wobei die den Meißel (1) entgegen dem Schnittdruck (Pfeil 4) belastende Rückstellkraft so bemessen ist, daß sie erst bei einer einachsigen Würfeldruckfestigkeit des zu schrämenden Gesteins von mindestens 20 N/mm² überwunden wird.

2. Einrichtung nach Anspruch 1, dadurch gekennzeichnet, daß die Rückstellkraft mindestens 3 000 N beträgt.

3. Einrichtung nach Anspruch 1 oder 2, dadurch gekennzeichnet, daß die Feder (5) gegen ein verstellbares und im Betrieb festlegbares Widerlager (30, 31) abgestützt ist.

4. Einrichtung nach Anspruch 3, dadurch gekennzeichnet, daß die Feder (5) in an sich bekannter Weise von einer auf den Ventilkegel (6) wirkenden und gleichachsig mit diesem angeordneten Schraubenfeder (5) gebildet ist und daß das Widerlager von einem im Ventilgehäuse (32) oder im Meißelhalter (2) verschraubbaren Federteller (30, 31) gebildet ist.

5. Einrichtung nach einem der Ansprüche 1 bis 4, dadurch gekennzeichnet, daß das Absperrventil (7) in an sich bekannter Weise einen entgegen der Strömungsrichtung des Wassers öffnenden Ventilkegel (6) aufweist, der einen im Ventilgehäuse (32) dicht geführten Ventilschaft (8) aufweist, und daß mit dem Ventilkegel (6) ein in Strömungsrichtung hinter demselben angeordneter in einem Zylinder (15) dicht geführter Kolben (14) starr verbunden ist, woben in einem Raum (16) zwischen dem Ventilkegel (6) und dem Kolben (14) wenigstens eine Austrittsöffnung (17) für das Wasser mündet.

6. Einrichtung nach Anspruch 5, dadurch gekennzeichnet, daß der Durchmesser (e) des Kolbens (14) größer ist als der Durchmesser (c) des Schaftes (8) des Ventilkegels (6).

## Claims

1. A device for cooling the bits (1) of a continuous mining machine, comprising a nozzle (22), arranged adjacent the bit (1), for cooling water to be ejected under pressure, the water supply to said nozzle being closable by a shutoff valve (7), the bit (1) being supported on the bit holder (2) for limited axial shifting movement under the action of the cutting pressure and against a restoring force which is provided by a spring (5) and by the water pressure, and the shutoff valve (7) being coupled with the bit (1) by a coupling member (9) such that it opens upon a shifting movement of the bit in the direction (4) of the cutting pressure, the restoring force acting on the bit (1) against the cutting pressure (arrow 4) is rated such that it is only overcome at a uniaxial cubic compression strength of the rock to be cut of at least 20 N/mm².

2. A device as claimed in claim 1, characterised in that the restoring force is at least 3 000 N.

3. A device as claimed in claim 1 or 2, characterised in that the spring (5) is supported against an adjustable abutment (30, 31) which can be fixed in position during operation.

4. A device as claimed in claim 3, characterised in that the spring (5) in a manner known per se is formed by a helical spring (5) acting on the valve cone (6) and being arranged coaxially therewith and that the abutment is formed of a spring collar (30, 31) screwed into the valve body (32) or into the bit holder (2).

5. A device as claimed in any one of claims 1 to 4, characterised in that the shutoff valve (7) in a manner know per se is provided with a valve cone (6) which opens in opposite direction to the direction of flow of the water and which has a valve shaft (8) sealingly guided within the valve body (32), and that a piston (14) arranged downstream of the valve cone (6) and sealingly guided within a cylinder (15) is rigidly connected with the valve cone (6), at least one outlet opening (17) for the water leading into a space (16) located between the valve cone (6) and the piston (14).

6. A device as claimed in claim 5, characterised in that the diameter (e) of the piston (14) is greater than the diameter (c) of the shaft (8) of the valve cone (6).

## Revendications

1. Dispositif pour refroidir l'outil (1) d'une haveuse, comprenant une buse (22) qui est disposée dans la région de l'outil (1), pour l'eau de refroidissement à projeter sous pression, (1) et dont l'alimentation en eau peut être fermée par une soupape d'arrêt (7), l'outil (1) étant monté sur le porte-outil (2) de manière à se déplacer en translation axiale sur une distance limitée sous l'effet de la pression de coupe, et contre une force rappel formée par la force d'un ressort (5) et la pression de l'eau, et la soupape d'arrêt (7) étant accouplée à l'outil par un organe d'accouplement (9) de manière à s'ouvrir lors d'un déplacement en translation de l'outil dans le sens (4) de la pression de coupe, la force de rappel qui sollicite l'outil (1) en sens inverse de la pression de coupe (flèche 4) étant déterminée de manière à n'être surmontée qu'en présence d'une résistance à l'écrasement monoaxial de la roche à abbattre d'au moins 20 N/mm².

2. Dispositif selon la revendication 1, caractérisé en ce que la force de rappel est d'au moins 3 000 N.

3. Dispositif selon la revendication 1 ou 2, caractérisé en ce que le ressort (5) est appuyé sur une butée (30, 31) réglable et susceptible d'être fixée en service.

4. Dispositif selon la revendication 3, caractérisé en ce que le ressort (5) est formé, d'une façon connue en soi, par un ressort hélicoïdal (5) qui agit sur le cône de soupape (6) et est disposé coaxialement à celui-ci et en ce que la butée est formée d'un ressort assiette (30, 31) qui peut être vissé dans le corps de soupape (32) ou dans le porte-outil (2).

5. Dispositif selon l'une des revendications 1 à 4 caractérisé en ce que la soupape d'arrêt (7) comporte, d'une façon connue en soi, un cône de soupape (6) s'ouvrant en sens inverse du sens de l'écoulement de l'eau, qui comporte une tige de soupape (8) guidée de manière étanche dans le corps de soupape (32), et en ce qu'un piston (14) guidé de manière étanche dans un cylincre (15) et disposé en amont du cône de soupape (6) dans le sens de l'écoulement, est relié rigidement au cône de soupape (6), au moins un orifice de sortie (17) pour l'eau débouchant dans une chambre (16) ménagée entre le cône de soupape (6) et le piston (14).

6. Dispositif selon la revendication 5, caractérisé en ce que le diamètre (e) du piston (14) est plus grand que le diamètre (c) de la tige (8) du cône de soupape (6).

FIG.1

FIG.2

1